# EUROPÄISCHE PATENTANMELDUNG

(11) **EP 0 704 889 A2**
(43) Veröffentlichungstag der Anmeldung: **03.04.1996**
(21) Anmeldenummer: 95114751.1
(22) Anmeldetag: 19.09.1995
(51) Int. Cl.: H01L 21/66

(54) **Leistungshalbleiterbauelement mit monolithisch integriertem Messwiderstand und Verfahren zu dessen Herstellung**

(30) Priorität: 29.09.1994 DE 4434893
(71) Anmelder: SIEMENS AKTIENGESELLSCHAFT, D-80333 München (DE)
(72) Erfinder: Hierold, Christofer, Dr., D-81739 München (DE)

(57) **Zusammenfassung**

Der Anmeldungsgegenstand betrifft ein Leistungshalbleiterbauelement mit einer Zellenstruktur (Z), bei dem in einem lateralen Bereich zwischen Zellen (Z1, Z2) des Leistungshalbleiterbauelements eine metallische Widerstandsbahn (AL) vorgesehen ist, die vom Halbleiterkörper (H) und von einer Steuerelektrode (G) durch eine nichtleitende Schicht (OX) isoliert ist. Der hierdurch erzielte Vorteil liegt vor allem darin, daß die aktive Fläche des Bauelementes durch die Widerstandsbahn nicht verkleinert wird und die Widerstandsbahn gleichzeitig mit einer metallischen Schicht (AL1, AL2) zur Kontaktierung einer Hauptelektrode (E) erzeugt werden kann.

## Beschreibung

Aus der europäischen Patentanmeldung mit der Veröffentlichungsnummer 0 390 485 ist eine MOS-Pilotstruktur für einen Transistor mit isoliertem Gate bekannt, bei der zwischen den Zellen des Transistors ein metallischer Kontaktstreifen vorgesehen ist, der zum einen die Anschlüsse der Zellen der MOS-Pilotstruktur und zum anderen die MOS-Pilotstruktur mit einem metallischen Anschlußgebiet für einen externen Meßwiderstand verbindet. Von Nachteil ist hierbei, daß der Meßwiderstand extern hinzugefügt werden muß und durch die Zuleitungen parasitäre Widerstände und Induktivitäten die Meßgenauigkeit und das dynamische Verhalten der Pilotstruktur negativ beeinflussen können. Wird der Meßwiderstand zur Temperaturmessung verwendet, so kann mit einem externen Widerstand die Temperatur in der Nähe der gefährdeten Sperrschichten nicht zuverlässig erfaßt werden, wobei die gemessene Temperatur von der tatsächlichen Temperatur zum Teil bis zu 20 Prozent abweicht.

Der Erfindung liegt nun die Aufgabe zugrunde, ein Leistungshalbleiterbauelement anzugeben, bei dem die genannten Nachteile vermieden werden, ohne daß dabei bei gleicher Halbleiterfläche die aktive Fläche verkleinert wird und ohne daß bei der Herstellung des Leistungshalbleiterbauelements zusätzliche Prozeßschritte erforderlich sind.

Diese Aufgabe wird erfindungsgemäß durch die Merkmale des Patentanspruchs 1 gelöst.

Die Gegenstände der Patentansprüche 2 bis 4 betreffen bevorzugte Ausgestaltungen der Erfindung und der Gegenstand des Patentanspruchs 5 betrifft ein Verfahren zur Herstellung des erfindungsgemäßen Leistungshalbleiterbauelements.

Nachfolgend wird die Erfindung anhand der Zeichnung näher erläutert. Dabei zeigt:
- Figur 1: einen Ausschnitt eines erfindungsgemäßen Leistungshalbleiterbauelements in der Draufsicht,
- Figur 2: eine Schnittdarstellung eines in Figur 1 gekennzeichneten Schnittes und
- Figur 3: ein elektrisches Ersatzschaltbild des erfindungsgemäßen Leistungshalbleiterbauelements.

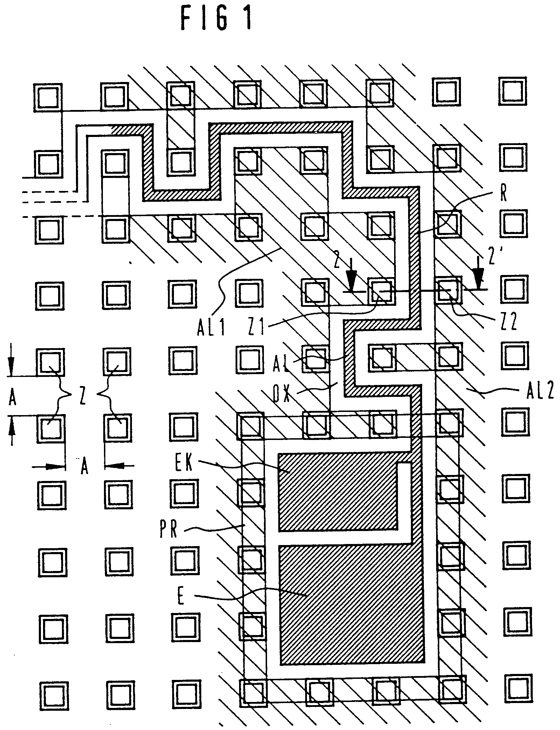

Figur 1 zeigt ein Leistungshalbleiterbauelement mit einer Zellenstruktur Z in der Draufsicht, wobei alle Zellen bis auf die Zellen in unmittelbarer Nachbarschaft von Kontaktierungsgebieten E und EK, also auch die Zellen in unmittelbarer Nachbarschaft einer metallischen widerstandsbahn AL zueinander den gleichen Zellenabstand A aufweisen. Die regelmäßige Zellenstruktur wird also nur durch die Kontaktierungsgebiete (bond pads) unterbrochen und es geht nur hierfür aktive Fläche des Leistungshalbleiterbauelements verloren. Die Kontaktierungsgebiete EK und E sind vorzugsweise durch einen in den Halbleiterkörper implantierten p⁺-dotierten Ring PR von den Zellen getrennt. Die Widerstandsbahn AL ist dabei durch eine nichtleitende Schicht OX, beispielsweise eine SiO₂-Schicht, vom Halbleiterkörper getrennt.

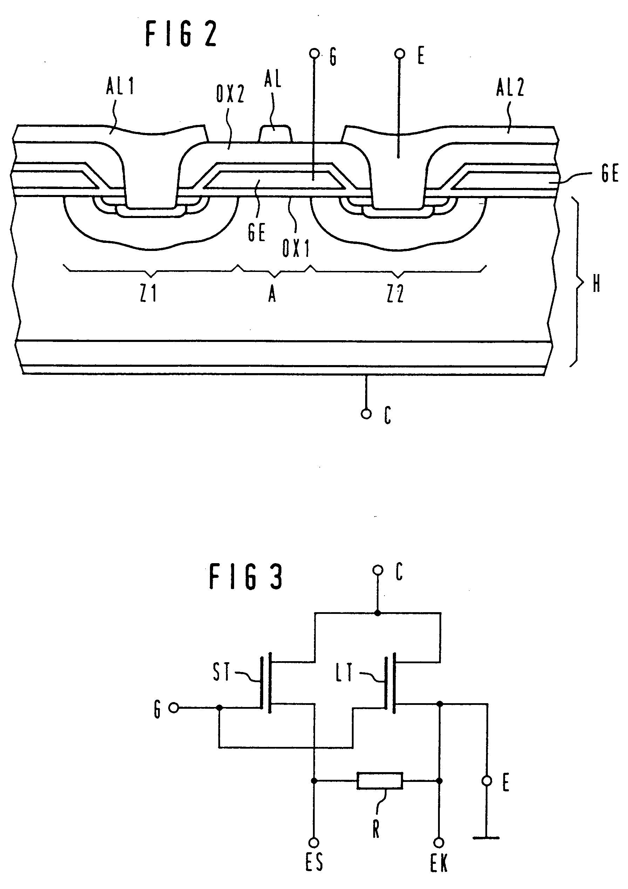

Wird bei einer Strommessung zur Vermeidung von Meßfehlern aufgrund von Übergangswiderständen eine sogenannte Vierleitertechnik angewandt, so ist neben der Hauptelektrode E ein Kontaktierungsgebiet EK für einen sogenannten Kelvinanschluß vorgesehen, das ebenfalls mit der Widerstandsbahn AL verbunden ist. In Figur 1 ist ferner ein Schnitt 2-2' durch die Zelle Z1, die Widerstandsbahn AL und die Zelle Z2 angedeutet, der in Figur 2 als Schnittdarstellung gezeigt ist.

Aus Figur 2 ist ein Halbleiterkörper H ersichtlich, der zwei Zellen Z1 und Z2 im Zellabstand A aufweist. Auf der Strukturierungsoberfläche des Halbleiterkörpers H sind durch eine durch eine nichtleitende Schicht OX1, beispielsweise eine SiO₂-Schicht, vom Halbleiterkörper H getrennte Gateelektroden G in einem den Zellabstand A überlappenden Bereich angeordnet. Ferner ist ein zentraler Bereich der Zellen Z1 und Z2 über Durchbrüche in einer Oxidschicht OX2 und der Oxidschicht OX1 mit der metallischen Kontaktierungsschicht AL1 bzw. AL2, die beispielsweise aus Aluminium besteht, verbunden. In einem lateralen Bereich zwischen den Zellen Z1 und Z2 befindet sich die Widerstandsbahn AL, die beispielsweise ebenfalls aus Aluminium besteht, oberhalb der Gateelektrode GE und ist von dieser bzw. vom Halbleiterkörper H durch nichtleitende Schichten OX1 und OX2 isoliert.

Die Widerstandsbahn AL kann sowohl im Falle eines integrierten Widerstandes zur Strommessung als auch im Falle eines integrierten Widerstandes zur Temperaturmessung beispielsweise, wie in Figur 1 gezeigt, einseitig mit einem Anschlußgebiet E einer Hauptelektrode des Leistungshalbleiterbauelements verbunden sein, wobei im Falle der Temperaturmessung aktive Fläche Leistungshalbleiterbauelementes gespart wird.

Im Falle eines integrierten Widerstandes zu Temperaturmessung können jedoch auch beide Enden der Widerstandsbahn AL mit einem jeweiligen separaten Anschlußgebiet für den Widerstand R verbunden sein und diese Anschlußgebiete wiederum mit einer externen Konstantstromquelle beschaltet sein.

Wird der Meßwiderstand R als Temperatursensor verwendet, ist dieser vorzugsweise an der heißesten Stelle des Leistungshalbleiters vorzusehen. Da die Widerstandsbahn die metallische Kontaktierungsschicht eines Hauptanschlusses, beispielsweise eines Emitteranschlusses E unterbricht, ist darauf zu achten, daß keine isolierten Inseln entstehen und der Stromfluß auf der Oberfläche lokal konzentriert wird.

In Figur 3 ist ein elektrisches Ersatzschaltbild dargestellt das ein erfindungsgemäßes Leistungshalbleiterbauelement in Form eines IGBT's mit integriertem Meßwiderstand zur Strommessung zeigt, wobei der IGBT aus einem Lasttransistor LT und einem Sensortransistor ST besteht. Der Sensortransistor ST und der Lasttransistor LT sind als Stromspiegel beschaltet, wobei der Lasttransistor aus ca. 1000 mal mehr Zellen besteht als der Sensortransistor. Die Kollektoranschlüsse der beiden Transistoren sind mit einem gemeinsamen Kollektoranschluß C des Leistungshalbleiterbauelements und die Gateanschlüsse der beiden Transistoren mit einem gemeinsamen Gateanschluß G des Leistungshalbleiterbauelements verbunden. Der Emitteranschluß des Sensortransistors ST ist als externer Sensoranschluß ES und der Emitter des Lasttransistors LT ist als externer Gateanschluß E der praktisch den gesamten Laststrom führt, und als externer Kelvinanschluß, der nur den Meßstrom führt, herausgeführt. Der Sensoranschluß ES ist über den integrierten Widerstand R mit dem Emitteranschluß E beziehungsweise mit dem Kelvinanschluß EK verbunden.

Der Zellabstand A beträgt beispielsweise 50 µm und die Breite der Widerstandsbahn beträgt beispielsweise 5 µm. Die Länge der Widerstandsbahn ist durch den Widerstandswert bestimmt und kann somit den Erfordernissen entsprechend angepaßt werden. Ein typischer Wert für den Schichtwiderstand der Widerstandsbahn ist 5 mOhm/Square. Die Größe der Bond pads beträgt beispielsweise 50 µm x 100 µm. Bei Widerstandsbahnen mit kleinem Grundwiderstand, also beispielsweise 10 bis 100 Ohm, ist die Vierleitertechnik der Zweileitertechnik vorzuziehen, da das Meßergebnis durch die Übergangswiderstände der Kontakte verfälscht wird.

Die Widerstandsbahn AL kann vorzugsweise mäanderförmig zwischen den Zellen hindurchgeführt werden.

Unter Leistungshalbleiterbauelementen sind bevorzugt Transistoren mit isoliertem Gate zu verstehen, wie beispielsweise Leistungs-MOS-FETS und IGBT's (Isolated Gate Bipolar Transistor).

Vorteilhafterweise wird die Widerstandsbahn AL gleichzeitig im selben Prozeßschritt mit der metallischen Kontaktierung AL1 und AL2 der Zellen Z1 und Z2 erzeugt.

## Patentansprüche

1. Leistungshalbleiterbauelement mit einer Zellenstruktur (Z),
bei dem in einem lateralen Bereich zwischen Zellen (Z1, Z2) des Leistungshalbleiterbauelements eine metallische Widerstandsbahn (AL) zur Bildung eines Meßwiderstandes vorgesehen ist, die vom Halbleiterkörper (H) und von einer Steuerelektrode (GE) durch mindestens eine nichtleitende Schicht (OX1, OX2) isoliert ist und
bei dem jeweils die Zellen (Z1, Z2) links und rechts von der Widerstandsbahn (AL) zueinander ebenfalls den regelmäßigen Zellenabstand (A) der Zellenstruktur (Z) aufweisen.

2. Leistungshalbleiterbauelement nach Anspruch 1,
bei dem eine metallische Schicht (AL1, AL2) zur Kontaktierung einer Hauptelektrode (E) des Leistungshalbleiterbauelement an einer Stelle mit der Widerstandsbahn (AL) verbunden ist und die Widerstandsbahn aus dem gleichen Material besteht wie die metallische Schicht (AL1, AL2) zur Kontaktierung.

3. Leistungshalbleiterbauelement nach Anspruch 1 oder 2,
bei dem die Widerstandsbahn (AL) mäanderförmig ist.

4. Leistungshalbleiterbauelement nach einem der vorhergehenden Ansprüche,
bei dem die Widerstandsbahn im wesentlichen aus Aluminium besteht.

5. Verfahren zur Herstellung eines Leistungshalbleiterbauelementes nach einem der Ansprüche 2 bis 4,
bei dem die Widerstandsbahn (AL) gleichzeitig mit der metallischen Schicht (AL1, AL2) zur Kontaktierung einer Hauptelektrode (E) erzeugt wird.
